Europäisches Patentamt

European Patent Office

Office européen des brevets

(19)

(11) Veröffentlichungsnummer: **0 156 017**
**B1**

(12) **EUROPÄISCHE PATENTSCHRIFT**

(45) Veröffentlichungstag der Patentschrift:
**15.07.87**

(51) Int. Cl.⁴: **H 01 F 7/22**

(21) Anmeldenummer: **84115317.4**

(22) Anmeldetag: **12.12.84**

(54) **Einrichtung zur Halterung des Gehäuses einer supraleitenden Magnetwicklung.**

(30) Priorität: **27.02.84 DE 3407058**

(43) Veröffentlichungstag der Anmeldung:
**02.10.85 Patentblatt 85/40**

(45) Bekanntmachung des Hinweises auf die Patenterteilung:
**15.07.87 Patentblatt 87/29**

(84) Benannte Vertragsstaaten:
**DE GB NL**

(56) Entgegenhaltungen:
DE - A - 2 523 007
DE - B - 1 514 633

IEEE TRANSACTIONS ON NUCLEAR SCIENCE, Band NS-24, Nr. 3, Juni 1977, Seiten 1109-1111, IEEE, New York, US; E. ACERBI u.a.: "Model magnet for the proposed superconducting cyclotron at the university of Milan"
IEEE TRANSACTIONS ON MAGNETICS, Band MAG-17, Nr. 1, Januar 1981, Seiten 199-202, IEEE, New York, US; E.M.W. LEUNG u.a.: "The superconducting chicago cyclotron magnet - an old magnet with a new pair of energy efficient coils"
PROCEEDINGS OF THE 7TH SYMPOSIUM ON FUSION TECHNOLOGY, Grenoble, 24.-27. Oktober 1972, Seiten 285-295, Luxemburg, LU; A.P. MARTINELLI: "On a

(73) Patentinhaber: **Siemens Aktiengesellschaft Berlin und München, Wittelsbacherplatz 2, D-8000 München 2 (DE)**

(72) Erfinder: **Marsing, Helmut, Lärchenweg 8, D-8524 Neunkirchen (DE)**

(56) Entgegenhaltungen: (Fortsetzung)
*superconducting coil system for a large tokamak experiment"*
PATENTS ABSTRACTS OF JAPAN, Band 7, nr. 226 (E-202)[1371], 7. Oktober 1983
PATENTS ABSTRACTS OF JAPAN, Band 5, Nr. 70 (E-56)[742], 12. Mai 1981
IEEE TRANSACTIONS ON MAGNETICS, Band MAG-17, Nr. 5, September 1981, Seiten 1560-1566, IEEE, New York, US; H. DESPORTES: "Superconducting magnets for accelerators, beam lines and detectors"

# Beschreibung

Die Erfindung bezieht sich auf eine Einrichtung zur Halterung eines eine supraleitende Magnetwicklung aufnehmenden Wicklungsgehäuses, das auf Tieftemperatur zu kühlen ist, das von mindestens einem auf vergleichsweise höherer Temperatur zu haltenden Strahlungsschutzschild umgeben und mit diesem in einem auf etwa Raumtemperatur befindlichen Aussengehäuse angeordnet ist, wobei die Halterungseinrichtung mindestens ein starres rohrförmiges Stützelement aufweist, das zwischen dem Aussengehäuse und dem Wicklungsgehäuse angeordnet und mit dem Strahlungsschutzschild verbunden ist und zumindest teilweise aus schlecht wärmeleitendem Material besteht. Eine solche Halterungseinrichtung ist aus dem Bericht des «National Accelerator Laboratory», USA, Nr. TM-334A, 2791.000 vom 10.12.1971 mit dem Titel «The Heim Column» bekannt.

Bei supraleitenden Magneteinrichtungen wird vielfach innerhalb eines auf Raumtemperatur von etwa 300 K befindlichen Vakuum- bzw. Aussengehäuses ein Wicklungsgehäuse angeordnet, in dem sich die tiefzukühlende supraleitende Magnetwicklung befindet. Dieses Wicklungsgehäuse ist somit ebenfalls auf die Tieftemperatur zu kühlen und wird deshalb auch als Helium-Gehäuse bezeichnet. Aus thermischen Gründen ist zwischen dem Aussen- und dem Wicklungsgehäuse noch mindestens ein Strahlungsschutzschild oder -gehäuse vorgesehen, der im allgemeinen auf einer Temperatur zwischen etwa 40 K und 100 K gehalten wird. Für einen solchen Aufbau ist eine Halterungseinrichtung mit Zug- oder Stützelementen für alle drei Raumachsen erforderlich, über welche auf die tiefkalten Bauteile möglichst geringe Wärmemengen übertragen werden sollen. Für die Auslegung einer entsprechenden Halterungseinrichtung sind neben den vorhandenen Gewichtsmassen der Bauteile vielfach noch dynamische Komponenten wie z.B. infolge von Beschleunigungen im Transportfalle zu berücksichtigen.

Aufgrund dieser Forderungen wurden bisher verschiedenste Zug- oder Stützelemente eingesetzt, wobei unterschiedliche Werkstoffe, z.B. 18/8-CrNi-Stahl, Titan oder glasfaserverstärkte Kunststoffe, verwendet wurden. Dementsprechend besteht die aus dem eingangs genannten Bericht bekannte Halterungseinrichtung aus mehreren Stützelementen, die zwischen dem Aussengehäuse und dem Wicklungsgehäuse anzuordnen und mit einem Strahlungsschutzschild zu verbinden sind. Jedes Stützelement enthält dabei drei sich umschliessende rohrförmige Teile, wobei das äussere, an dem Aussengehäuse anliegende Rohr sowie das innere, an dem Wicklungsgehäuse anliegende Rohr aus glasfaserverstärktem Kunststoff bestehen und über das mittlere Rohr aus Aluminium miteinander verbunden sind. Durch die Verwendung von diesen Materialien mit unterschiedlichem Dehnungsverhalten und aufgrund einer entsprechenden Bemessung der einzelnen Rohrlängen kann dann erreicht werden, dass sowohl im Montagefall bei Raumtemperatur des gesamten Aufbaus einschliesslich des Wicklungsgehäuses als auch im Betriebsfalle bei Tieftemperatur dieses Gehäuses stets ein Form- und Kraftschluss über die Stützelemente zwischen dem Aussen- und dem Wicklungsgehäuse gewährleistet ist.

Derartige Halterungseinrichtungen sind jedoch entweder überdimensioniert, um die dynamischen Zusatzbelastungen während des Transportes übernehmen zu können; oder es werden spezielle Transportstützen vorgesehen, die vor Inbetriebnahme der Magneteinrichtung entfernt werden müssen. Überdimensionierte Halterungseinrichtungen führen jedoch zu entsprechend hohen Wärmeverlusten, während zusätzliche Transportstützen die Handhabung der Magneteinrichtung erschweren.

Aufgabe der vorliegenden Erfindung ist es deshalb, die eingangs genannte Halterungseinrichtung derart zu verbessern, dass über sie verhältnismässig geringe Wärmemengen von dem Aussengehäuse auf das gekühlte Wicklungsgehäuse übertragen werden und dass dennoch die während des Transportes auftretenden dynamischen Zusatzbelastungen ohne zusätzliche Transportstützen aufgefangen werden können.

Diese Aufgabe wird erfindungsgemäss dadurch gelöst, dass das Wicklungsgehäuse mittels mindestens einer schlecht wärmeleitenden Aufhängevorrichtung in dem Aussengehäuse aufgehängt ist, dass das rohrförmige Stützelement als hinsichtlich seiner Länge veränderbare Druckstütze gestaltet ist, so dass ein Formschluss mit dem Aussengehäuse und mit dem auf Raumtemperatur befindlichen Wicklungsgehäuse einzustellen ist, und dass dieses Stützelement mittels einer ein Federelement aufweisenden Befestigungsvorrichtung so an dem Strahlungsschutzschild angebracht ist, dass stets, d.h. auch bei Betriebstemperatur, ein Formschluss mit dem Aussengehäuse besteht, während sich zwischen dem Stützelement und dem Wicklungsgehäuse bei dieser Temperatur ein Spalt von mehreren mm Länge einstellt.

Die erfindungsgemässe Halterungseinrichtung stellt somit eine Kombination einer Aufhängung mit zusätzlichen Druckstützen dar. Dabei ist die Aufhängung der kalten Gewichtsmassen allein im stationären, d.h. im Betriebfalle wirksam, während im Nichtbetriebszustand wie z.B. im Transportfalle, in dem sich auch das Wicklungsgehäuse mit der Magnetwicklung auf Raumtemperatur befindet, über die eine oder mehrere Druckstützen ein zusätzlicher Kraftschluss zwischen dem Aussengehäuse und dem Wicklungsgehäuse besteht. Da die Druckstützen immer mit Hilfe der an dem Strahlungsschutzschild angebrachten Befestigungsvorrichtung an das Aussengehäuse gepresst werden, wird vorteilhaft bei zunehmender Abkühlung des aufgehängten Wicklungsgehäuses infolge der damit verbundenen Schrumpfung dieses Gehäuses der Kraftschluss zwischen den Druckstützen und dem Gehäuse aufgehoben. Eine Wärmeeinleitung über die Druckstützen auf das Wicklungsgehäuse ist somit im Betriebszustand ausgeschlossen. Wenn die Magnetwicklung, beispielsweise für einen Transport, aufgewärmt werden sollte, treten die eingebauten Stützelemente selbsttätig wieder in Funktion.

Vorteilhafte Ausgestaltungen der Halterungseinrichtung nach der Erfindung gehen aus den Unteransprüchen hervor.

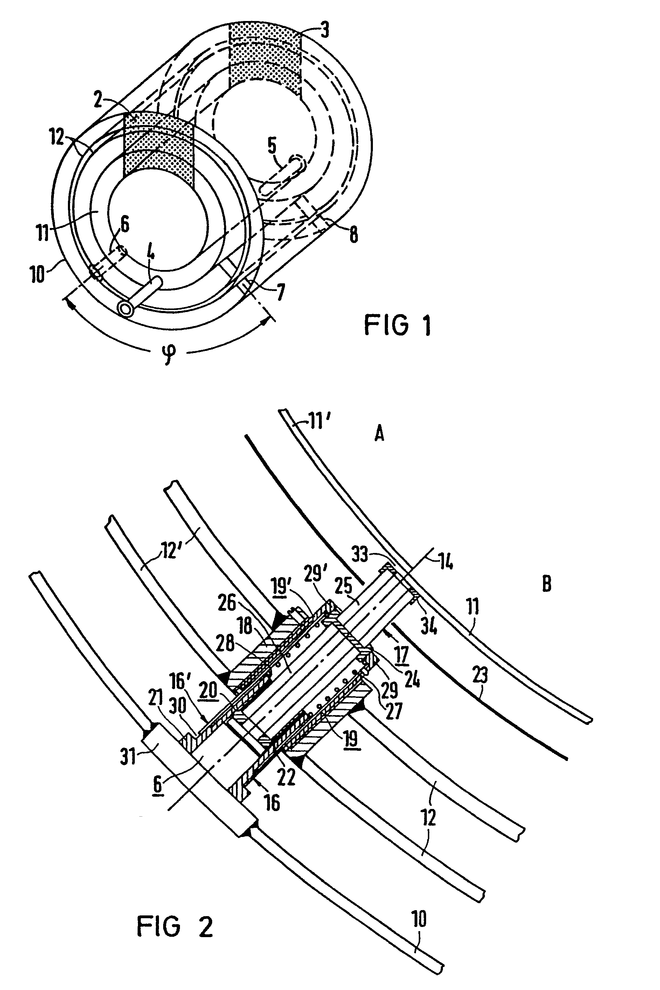

Zur weiteren Erläuterung der Erfindung und deren in den Unteransprüchen gekennzeichneten Weiterbildungen wird nachfolgend auf die Zeichnung Bezug genommen, in der Fig. 1 eine erfindungsgemässe Halterungsanordnung schematisch als Schrägansicht zeigt. Fig. 2 zeigt einen Längsschnitt durch ein Stützelement für diese Halterungsanordnung.

Die erfindungsgemässe Halterungseinrichtung kann für alle supraleitenden Magneteinrichtungen vorgesehen werden, deren Wicklungen in einem eigenen Wicklungsgehäuse anzuordnen sind, das auf die supraleitende Betriebstemperatur mit abzukühlen ist und sich innerhalb eines Aussengehäuses, im allgemeinen eines Vakuumgehäuses befindet, das auf Raumtemperatur liegt. Bei der Magneteinrichtung kann es sich beispielsweise um den Grundfeldmagneten einer Anlage zur Kernspintomographie handeln. Derartige Magneten müssen transportfähig sein, so dass der entsprechende Aufbau gegen die dabei auftretenden dynamischen Belastungen gesichert sein muss. Diese Forderung ist mit der erfindungsgemässen Halterungseinrichtung zu erfüllen.

Nach Fig. 1 umfasst die Halterungseinrichtung eine oder mehrere an sich bekannte Aufhängevorrichtungen 2 und 3 sowie eine vorbestimmte Anzahl von als Druckstützen dienenden Stützelementen 4 bis 8. Mit den Aufhängevorrichtungen 2 und 3 ist innerhalb eines Aussengehäuses 10 ein Wicklungsgehäuse 11 aufgehängt, das eine in der Figur nicht ausgeführte supraleitende Magnetwicklung umschliesst. Zwischen dem Aussengehäuse 10 und dem Wicklungsgehäuse 11 ist ein Strahlungsschutzschild 12 angeordnet, der ebenfalls von den Aufhängevorrichtungen 2 und 3 mitgetragen wird. Die Teile 11 und 12 sind im Betriebsfall, d.h. in ihrem abgekühlten Zustand allein durch diese Aufhängung innerhalb des Aussengehäuses 10 in nur vertikaler Richtung fixiert. Als Stabilisierung wirken hierzu nur die Schwerkraft und die Trägheit des aufgehängten Massengewichtes des Wicklungsgehäuses 11 und des Strahlungsschutzschildes 12. Derartige Aufhängevorrichtungen bestehen aus einem schlecht wärmeleitenden Material. So können beispielsweise gemäss dem Ausführungsbeispiel der Fig. 1 der Form der Aussenwand des inneren Wicklungsgehäuses 11 und der Innenwand des Aussengehäuses 10 angepasste platten- bzw. scheibenförmige Halteteile aus glasfaserverstärktem Kunststoff vorgesehen sein, über die das Wicklungsgehäuse 11 und der Strahlungsschutzschild 12 an ihren geodätisch höchsten Stellen mit dem Aussengehäuse 10 mechanisch starr verbunden sind. Neben derartigen Aufhängevorrichtungen können beispielsweise auch Seile oder Bänder aus schlecht wärmeleitenden Materialien zur Aufhängung des Wicklungsgehäuses 11 und des Strahlungsschutzschildes 12 dienen. Da eine Befestigung der Teile 11 und 12 allein durch eine Aufhängung für die insbesondere bei einem Transport auftretenden Stösse bzw. Beschleunigungskräfte nicht ausreichend ist, sind für diesen Fall die zusätzlichen Stützelemente vorgesehen. Von den in der Figur gezeigten Druckstützen, die nur im erwärmten Zustand des Wicklungsgehäuses 11 und des Strahlungsschutzschildes 12 wirksam sind, dienen die Stützelemente 4 und 5 einer stirnseitigen Abstützung in axialer Richtung, während von den für eine Abstützung in radialer Richtung erforderlichen Stützelementen drei Elemente 6 bis 8 ersichtlich sind. Dabei kann zwischen den z.B. in einer gemeinsamen Querschnittsebene liegenden bodenseitigen Druckstützen 6 und 7 ein Bogenwinkel ψ von etwa 90° eingeschlossen sein. Einzelheiten aller gleichartig ausgebildeten Druckstützen, beispielsweise des Elementes 6, gehen aus dem Längsschnitt der Fig. 2 näher hervor.

In Fig. 2 ist die Lage des radialen Stützelementes 6 zwischen entsprechenden Teilstücken des inneren Wicklungsgehäuses 11 und des Aussengehäuses 10 sowohl für den Fall einer erfolgten Abkühlung des Wicklungsgehäuses sowie des Strahlungsschutzschildes 12 als auch für den Fall angedeutet, dass sich alle Teile auf Raumtemperatur befinden. Zur Veranschaulichung dieser unterschiedlichen Temperaturverhältnisse ist durch das Stützelement 6 eine Schnittebene 14 eingezeichnet. Dementsprechend sollen sich die auf der linken Seite A der Schnittebene 14 befindlichen Teile in ihrer Position nach erfolgter Abkühlung befinden, während die rechte Figurenhälfte B die Verhältnisse bei Raumtemperatur wiedergeben sollen. Teile, die aufgrund der Abkühlung eine veränderte Lage einnehmen, sind dabei mit einem Strich an ihrem Bezugszeichen gekennzeichnet.

Gemäss dem in Fig. 2 dargestellten Ausführungsbeispiel des als Druckstütze dienenden Stützelementes 6 bilden zwei sich auf einen Teil ihrer Länge konzentrisch umschliessende Rohrstützen 16 und 17 aus einem glasfaserverstärkten Kunststoff ein Grundelement, wobei die äussere Rohrstütze 16 den doppelwandig ausgebildeten, beispielsweise mit flüssigem Stickstoff zu kühlenden Strahlungsschutzschild 12 und die innere Rohrstütze 17 das als Helium-Behälter ausgebildete Wicklungsgehäuse 11 zu dem als Vakuummantel dienenden Aussengehäuse 10 hin abstützen. Befestigt ist das gesamte Stützelement 6 an dem Strahlungsschutzschild 12. Hierzu ist dieser Schild mit einer rohrförmigen Gewindebuchse 18 aus Metall versehen, in welche eine entsprechende metallene Gewindehülse 19 einzuschrauben ist. Diese Hülse umgibt die Rohrstütze 16 und ist mit dieser starr verbunden, beispielsweise verklebt. An dem dem Aussengehäuse 10 zugewandten offenen Ende der Rohrstütze 16 ist in diese ein metallenes Druckstück 20 eingeschoben, über dessen verbreitertes, fussartiges Anschlagteil 21 sich die Rohrstütze 16 an dem Aussengehäuse 10 abstützen kann. Bei der Montage wird die Rohrstütze 16 mit dem in sie eingeschobenen Druckstück 20 durch Verdrehen der sie fest umgebenden Gewindehülse 19 gegen das Aussengehäuse 10 angestellt und gegen weitere Verdrehung gesichert. Daran anschliessend wird die innere Rohrstütze 17 in das Druckstück 20 eingeschraubt. Hierzu ist die innere Rohrstütze 17 an ihrem dem Aussengehäuse 10 zugewandten Ende mit einer metallenen Gewindehülse 22 fest ummantelt, die sich in ein entsprechendes Gewinde an der Innenseite des Druckstückes 20 einschrauben lässt.

Hierauf werden das als Helium-Behälter dienende Wicklungsgehäuse 11 sowie ein gegebenenfalls vorzusehender weiterer Strahlungsschutzschild 23, der auf einer Temperatur von etwa 30 K gehalten werden kann, montiert. Danach wird die Rohrstütze 17 in Richtung der Behälterwand des Wicklungsgehäuses 11 zurückgeschraubt und mittels eines Zwischenstückes 24 aus Metall drehgesichert. Dieses Zwischenstück, das kreisscheibenförmig ausgebildet ist, unterteilt die Rohrstütze 17 in ein dem Wicklungsgehäuse 11 zugewandtes Teilstück 25 und ein dem Aussengehäuse 10 zugewandtes Teilstück 26. An dem Zwischenstück 24 sind die beiden Teilstücke 25 und 26 starr befestigt, beispielsweise angeklebt. Das an der Rohrstütze 17 befestigte Zwischenstück 24 übernimmt die im Bereich des Stützelementes 6 unterbrochene Funktion des Strahlungsschutzschildes 12, indem es beispielsweise über in der Figur nicht ausgeführte Kupfer-Litzen an den Strahlungsschutzschild 12 thermisch angebunden wird.

Abgekühlt wird zweckmässigerweise zunächst der Strahlungsschutzschild 12, wobei er zu kleinerem Radius hin schrumpft. Um trotzdem einen Formschluss des Stützelementes 6 mit dem Aussengehäuse 10 zu gewährleisten, ist eine Spiralfeder 27 beispielsweise aus einer Kupfer-Beryllium-Legierung vorgesehen, die zwischen dem dem Wicklungsbehälter 11 zugewandten oberen Ende 28 des Druckstückes 20 und einem fussartig ausgebildeten Endstück 29 der mit dem Strahlungsschutzschild 12 starr verbundenen Gewindehülse 19 eingespannt ist. Die mit der Abkühlung des Strahlungsschutzschildes 12 verbundenen Dilatationsverschiebungen werden dann über Gleitbewegungen der Rohrstütze 16 mit der Gewindehülse 19 gegenüber dem Druckstück 20 sowie gegenüber dem Zwischenstück 24 ermöglicht. Es bildet sich so zwischen dem fussartigen Endstück 21 des Druckstückes 20 und der äusseren, mit dem Strahlungsschutzschild 12 starr verbundenen Rohrstütze 16 ein entsprechender Spalt 30 aus. Da sich das Stützelement 6 an einem Teil des Aussengehäuses 10 nur abstützt, d.h. dort nicht starr befestigt ist, sind auch geringe Gleitbewegungen des Stützelementes gegenüber dem Aussengehäuse möglich.

Bei nachfolgender Abkühlung des Wicklungsgehäuses 11 schrumpft dieses zu kleinerem Radius hin. Aufgrund seiner Aufhängung innerhalb des warmen Aussengehäuses 10 bildet sich dann ein Spalt 33 mit einer Ausdehnung a in radialer Richtung von mehreren Millimetern zwischen dem abgekühlten Wicklungsgehäuse 11' und dem ihm zugewandten Ende 34 der inneren Rohrstütze 17 des Stützelementes 6 aus. Der Wärmeübertragungsweg über das Stützelement 6 zu dem abgekühlten Wicklungsgehäuse 11' ist somit unterbrochen.

Gemäss dem in Fig. 2 gezeigten Ausführungsbeispiel wurde davon ausgegangen, dass die rohrförmigen Einzelteile des Stützelementes 6 kreisringförmige Querschnittsform haben. Es sind jedoch auch andere Querschnittsformen wie z.B. rechteckige oder ovale, geeignet.

## Patentansprüche

1. Einrichtung zur Halterung eines eine supraleitende Magnetwicklung aufnehmenden Wicklungsgehäuses (11), das auf Tieftemperatur zu kühlen ist, das von mindestens einem auf vergleichsweise höherer Temperatur zu haltenden Strahlungsschutzschild (12) umgeben und mit diesem in einem auf etwa Raumtemperatur befindlichen Aussengehäuse (10) angeordnet ist, wobei die Halterungseinrichtung mindestens ein rohrförmiges Stützelement (6) aufweist, das zwischen dem Aussengehäuse (10) und dem Wicklungsgehäuse (11) angeordnet und mit dem Strahlungsschutzschild (12) verbunden ist und zumindest teilweise aus schlecht wärmeleitendem Material besteht, dadurch gekennzeichnet, dass das Wicklungsgehäuse (11) mittels mindestens einer schlecht wärmeleitenden Aufhängevorrichtung (2, 3) in dem Aussengehäuse (10) aufgehängt ist und dass das rohrförmige Stützelement (4 bis 8)

α) als hinsichtlich seiner Länge veränderbare Druckstütze gestaltet ist, so dass ein Formschluss mit dem Aussengehäuse (10) und mit dem auf Raumtemperatur befindlichen Wicklungsgehäuse (11) einzustellen ist, und

β) mittels einer ein Federelement (27) aufweisenden Befestigungsvorrichtung (18, 19) so an dem Strahlungsschutzschild (12) angebracht ist, dass stets, d.h. auch bei Betriebstemperatur, ein Formschluss mit dem Aussengehäuse (10) besteht, während sich zwischen dem Stützelement (4 bis 8) und dem Wicklungsgehäuse (11) bei dieser Temperatur ein Spalt (33) von mehreren mm Länge einstellt.

2. Halterungseinrichtung nach Anspruch 1, dadurch gekennzeichnet, dass die Aufhängevorrichtung aus mehreren platten- oder scheibenförmigen Elementen (2, 3) aus einem schlecht wärmeleitenden Material besteht, die zwischen dem Wicklungsgehäuse (11), dem Strahlungsschutzschild (12) und dem Aussengehäuse (10) angeordnet sind.

3. Halterungseinrichtung nach Anspruch 2, dadurch gekennzeichnet, dass die Aufhängeelemente (2, 3) aus einem glasfaserverstärkten Kunststoff bestehen.

4. Halterungseinrichtung nach einem der Ansprüche 1 bis 3, dadurch gekennzeichnet, dass das Stützelement (6) zwei auf einen Teil ihrer Länge ineinandergeschobene Rohrstützen (16, 17) aufweist, von denen die erste Rohrstütze (16) starr mit dem Strahlungsschutzschild (12) verbunden ist und an ihrem dem Aussengehäuse zugewandten Ende ein eingeschobenes, rohrförmiges Druckstück (20) besitzt, das an dem Aussengehäuse (10) unter dem Druck einer Feder (27) anliegt, dass die Feder (27) mit ihrem von dem rohrförmigen Druckstück (20) abgewandten Ende starr mit dem Strahlungsschutzschild (12) verbundenen Teilen anliegt und dass die zweite, der Abstützung des Wicklungsgehäuses dienende Rohrstütze (17) in starrer Verbindung mit dem rohrförmigen Druckstück (20) steht.

5. Halterungseinrichtung nach Anspruch 4, dadurch gekennzeichnet, dass die erste Rohrstütze (16) in eine sich durch den Strahlungsschutzschild (12) erstreckende und mit diesem starr verbundene Gewindebuchse (18) einschraubbar ist.

6. Halterungseinrichtung nach Anspruch 5, dadurch gekennzeichnet, dass die erste Rohrstütze (16) mittels einer sie teilweise umschliessenden und mit ihr starr verbundenen Gewindehülse (19) in die Gewindebuchse (18) einschraubbar ist.

7. Halterungseinrichtung nach einem der Ansprüche 3 bis 6, dadurch gekennzeichnet, dass die zweite Rohrstütze (17) mit dem rohrförmigen Druckstück (20) über eine Gewindehülse (22) verbunden ist.

8. Halterungseinrichtung nach einem der Ansprüche 3 bis 7, dadurch gekennzeichnet, dass die Rohrstützen (16, 17) aus einem glasfaserverstärkten Kunststoffmaterial bestehen.

9. Halterungseinrichtung nach einem der Ansprüche 5, 6 oder 7, dadurch gekennzeichnet, dass die verschraubten Teile (18, 19, 20, 22) der Stützelemente (4 bis 8) aus Metall bestehen.

**Claims**

1. A device for supporting a winding housing (11) which accomodates a superconductive magnet winding, which housing is to be cooled to a low temperature, is surrounded by at least one radiation protection shield (12) which is to be maintained at a relatively higher temperature, and is arranged with the latter in an outer housing (10) which is at approximately room temperature, the support device comprising at least one tubular support element (6) which is arranged between the outer housing (10) and the winding housing (11) and which is connected to the radiation shield (12) and consists at least in part of poorly heat conducting material, characterised in that the winding housing (11) is suspended in the outer housing (10) by means of at least one poorly heat conducting suspension device (2, 3); and that the tubular support element (4 to 8)

α) is formed as a pressure support the length of which can be varied, so that a shape locking with the outer housing (10) and with the winding housing (11), which is at room temperature, can be effected, and

β) by means of a fastening device (18, 19) provided with a spring element (27), is mounted on the radiation protection shield (12) in such manner that at all times, i.e. even at operating temperature, a shape locking exists with the outer housing (10), whilst, at this temperature, a gap (33) of several mm length occurs between the support element (4 to 8) and the winding housing (11).

2. A support device as claimed in Claim 1, characterised in that the suspension device consists of a plurality of plate-shaped or disc-shaped elements (2, 3) which are made of a poorly heat conducting material and which are arranged between the winding housing (11), the radiation protection shield (12) and the outer housing (10).

3. A support device as claimed in Claim 2, characterised in that the suspension elements (2, 3) are made of glass fibre-reinforced synthetic resin material.

4. A support device as claimed in one of Claims 1 to 3, characterised in that the support element (6) comprises two tubular supports (16, 17) which are inserted one in the other along part of their length, and of which a first tubular support (16) is rigidly connected to the radiation protection shield (12) and at its end facing towards the outer housing contains an inserted, tubular pressure element (20) which bears against the outer housing (10) under the pressure of a spring (27); that at its end which faces away from the tubular pressure element (20), the spring (27) bears against elements which are rigidly connected to the radiation protection shield (12); and that the second tubular support (17), which serves to support the winding housing, is rigidly connected to the tubular pressure element (20).

5. A support device as claimed in Claim 4, characterised in that the first tubular support (16) can be screwed into a threaded bush (18) which extends through the radiation protection shield (12) and is rigidly connected thereto.

6. A support device as claimed in Claim 5, characterised in that the first tubular support (16) can be screwed into the threaded bush (18) by means of a threaded sleeve (19) which partially surrounds the first tubular support and is rigidly connected thereto.

7. A support device as claimed in one of Claims 3 to 6, characterised in that the second tubular support (17) is connected to the tubular pressure element (20) through a threaded sleeve (22).

8. A support device as claimed in one of Claims 3 to 7, characterised in that the tubular supports (16, 17) are made of a glass fibre-reinforced synthetic resin material.

9. A support device as claimed in one of Claims 5, 6 or 7, characterised in that the threaded parts (18, 19, 20, 22) of the support elements (4 to 8) are made of metal.

**Revendications**

1. Dispositif de support pour un carter de bobinage (11), destiné à recevoir un bobinage magnétique supraconducteur, qui doit être refroidi à une basse température, qui est entouré d'au moins un écran (12) de protection contre le rayonnement, à maintenir à une température comparativement plus élevée, et disposé avec ce dernier dans un carter extérieur (10) qui est sensiblement à la température ambiante, ledit dispositif de support comportant au moins un élément d'appui tubulaire (6) qui est disposé entre le carter extérieur (10) et le carter bobinage (11) et est relié à l'écran (12) de protection contre le rayonnement, en étant réalisé, au moins partiellement, avec un matériau mauvais conducteur de la chaleur, caractérisé par le fait que le carter de bobinage (11) est suspendu dans le carter extérieur (10) au moyen d'au moins un dispositif de suspension (2, 3) mauvais conducteur de la chaleur, et que l'élément d'appui tubulaire (4 à 8)

α) est réalisé sous la forme d'un appui de pression, dont la longueur est modifiable, de façon à réaliser une liaison par formes complémentaires avec le carter extérieur (10) et avec le carter de bobinage (11) qui est à la température ambiante, et

β) est monté à l'aide d'un dispositif de fixation possédant un élément élastique (27) de telle façon sur l'écran de protection contre le rayonnement (12), qu'en permanence, c'est-à-dire même à la température de fonctionnement, il existe une liaison par formes complémentaires avec le carter extérieur (10), alors que s'établit, à cette température, entre l'élément d'appui (4 à 8) et le carter de bobinage (11), une fente (33) ayant une longueur de plusieurs mm.

2. Dispositif de support selon la revendication 1, caractérisé par le fait que le dispositif de suspension est constitué par plusieurs éléments en forme de plaques ou de disques (2, 3), éléments qui sont faits avec un matériau mauvais conducteur de la chaleur et qui sont disposés entre le carter de bobinage (11), l'écran de protection contre le rayonnement (12) et le carter extérieur (10).

3. Dispositif de support selon la revendication 2, caractérisé par le fait que les éléments de suspension (2, 3) sont constitués avec une matière plastique renforcée par des fibres de verre.

4. Dispositif de support selon l'une des revendications 1 à 3, caractérisé par le fait que l'élément d'appui tubulaire (6) comporte deux embouts tubulaires d'appui (16, 17) qui sont insérés l'un dans l'autre sur une partie de leur longueur, embouts tubulaires d'appui dont le premier (16) est relié rigidement à l'écran de protection contre le rayonnement (12) et possède, à son extrémité qui est voisine du carter extérieur, une pièce tubulaire de pression insérée (20) et portant contre le carter extérieur (10), sous la pression d'un ressort (27), que le ressort (27) porte, par son extrémité qui est éloignée de la pièce tubulaire de pression (20), contre des éléments reliés rigidement à l'écran de protection contre le rayonnement (12), et que le second embout tubulaire d'appui (17), qui sert d'appui pour la cuve de bobinage, est en liaison rigide avec la pièce tubulaire de pression (20).

5. Dispositif de support selon la revendication 4, caractérisé par le fait que le premier embout tubulaire d'appui (16) est susceptible d'être vissé dans une douille filetée (18) qui s'étend à travers l'écran de protection contre le rayonnement (12) et qui est reliée rigidement à celui-ci.

6. Dispositif de support selon la revendication 5, caractérisé par le fait que le premier embout tubulaire d'appui (16) est susceptible d'être vissé dans la douille filetée (18), à l'aide d'un tube fileté (19) qui l'entoure partiellement et qui est reliée rigidement audit embout tubulaire d'appui (16).

7. Dispositif de support selon l'une des revendications 3 à 6, caractérisé par le fait que le second embout tubulaire d'appui (17) est relié, par l'intermédiaire d'un tube fileté (22), à la pièce d'appui tubulaire (20).

8. Dispositif de support selon l'une des revendications 3 à 7, caractérisé par le fait que les embouts tubulaires d'appui (16, 17) sont constitués avec une matière plastique qui est renforcée à l'aide de fibres de verre.

9. Dispositif de support selon l'une des revendications 5, 6 ou 7, caractérisé par le fait que les parties (18, 19, 20, 22) des éléments d'appui (4 à 8) qui sont susceptibles d'être vissées, sont réalisées avec un métal.

0 156 017

FIG 1

FIG 2

7